# EUROPÄISCHE PATENTSCHRIFT

(11) **EP 0 510 227 B1**
(45) Veröffentlichungstag und Bekanntmachung des Hinweises auf die Patenterteilung: **27.03.1996**
(21) Anmeldenummer: 91106616.5
(22) Anmeldetag: 24.04.1991
(51) Int. Cl.: H03G 11/00

(54) **Schaltungsanordnung zur Signalbegrenzung und Feldstärkendetektion**
Circuit for signal limitation and for detection of electromagnetic field strength
Circuit pour limitation de signal et pour détection de l'intensité d'un champ électromagnétique

(43) Veröffentlichungstag der Anmeldung: 28.10.1992
(73) Patentinhaber: SIEMENS AKTIENGESELLSCHAFT, D-80333 München (DE)
(72) Erfinder: Fenk, Josef, Dipl.-Ing., W-8057 Eching/Offenburg (DE); Veit, Werner, Dipl.-Ing., W-8000 München 83 (DE)

(56) Entgegenhaltungen:
- US-A- 4 429 416
- PROCEEDINGS OF THE BIPOLAR CIRCUITS AND TECHNOLOGY MEETING, MINEAPOLIS, 17-18 SEPTEMBER, 1990, pages 244-247, IEEE, New York; J. Fenk et al.: " An RF Front-End for Digital Radio"

## Beschreibung

Die Erfindung betrifft eine Schaltungsanordnung zur Signalbegrenzung und Feldstärkedetektion nach dem Oberbegriff des Patentanspruches 1.

Bei Empfangsschaltungen in der Rundfunk- und Fernsehtechnik sowie der Mobilfunktechnik werden häufig sogenannte Feldstärkemonitore benötigt. Wie bei J. Fenk, W. Birth, R. G. Irvine, P. Sehrig, K. R. Schon, An FR Front-End For Digital Mobil Radio, IEEE 1990 Bipolar Circuits and Technology Meeting 11.2, beschrieben ist, besteht ein derartiger Feldstärkemonitor beispielsweise aus einem mehrstufien - in diesem Fall siebenstufigen - Begrenzerverstärker, an den eine siebenstufige Feldstärkedetektorschaltung angeschlossen ist. Um Störungen durch auftretende Offsetspannungen bei der Kopplung der einzelnen Begrenzerstufen zu vermeiden, sind alle Begrenzerstufen miteinander wechselstromgekoppelt. Beim Betrieb mit einer üblichen Zwischenfrequenz von ca. 450 kHz werden dafür jedoch relativ große Kapazitäten benötigt. Diese erfordern bei einer Realisierung in integrierter Schaltungstechnik eine relativ große Fläche, was wiederum zu einem großen Flächenbedarf der gesamten integrierten Schaltung führt.

Zudem ist aus der US-PS 4,429,416 eine Schaltungsanordnung zur Signalbegrenzung und Feldstärkedetektion bekannt, bei der lediglich die erste der in Reihe geschalteten Begrenzerstufen wechselstrommäßig an den Eingang gekoppelt ist, während die Begrenzerstufen untereinander gleichstromgekoppelt sind. Jedoch können hier Störungen durch Offsetspannungen aufgrund der Gleichstromkopplung der Begrenzerstufen untereinander auftreten.

Aufgabe der Erfindung ist es, eine Schaltungsanordnung zur Signalbegrenzung und Feldstärkedetektion anzugeben, die Störungen durch Offsetspannungen vermeidet und bei deren Realisierung in integrierter Schaltungstechnik eine geringere Fläche benötigt wird.

Diese Aufgabe wird bei einer gattungsgemäßen Schaltungsanordnung durch das kennzeichnende Merkmal des Patentanspruches 1 gelöst. Ausgestaltungen und Weiterbildungen des Erfindungsgedankens sind in Unteransprüchen gekennzeichnet.

Die Erfindung wird nachfolgend anhand der in den Figuren der Zeichnung dargestellten Ausführungsbeispiele näher erläuert.

Es zeigt:
- FIG 1: eine Ausführungsform einer erfindungsgemäßen Schaltungsanordnung in einem Prinzipschaltbild,
- FIG 2: eine erste Ausführungsform einer Begrenzerstufe bei einer erfindungsgemäßen Schaltungsanordnung,
- FIG 3: eine zweite Ausführungsform einer Begrenzerstufe bei einer erfindungsgemäßen Schaltungsanordnung,
- FIG 4: eine dritte Ausführungsform einer Begrenzerstufe einer erfindungsgemäßen Schaltungsanordnung,
- FIG 5: eine Ausführungsform einer Detektorstufe einer erfindungsgemäßen Schaltungsanordnung und
- FIG 6: eine Ausführungsform einer Referenzspannungsquelle bei einer erfindungsgemäßen Schaltungsanordnung.

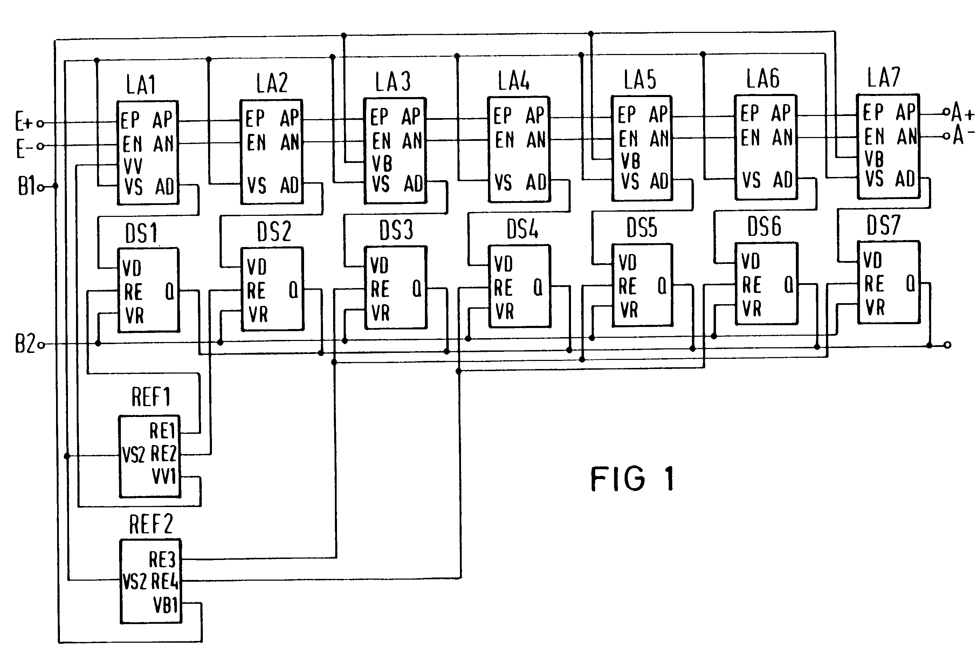

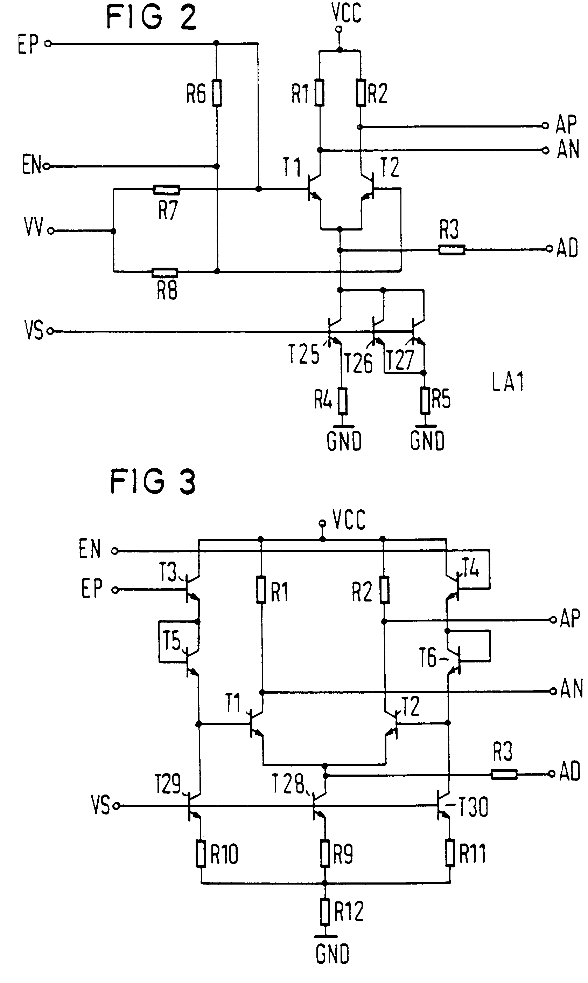

Gemäß FIG 1 weist das Ausführungsbeispiel n = 7 hintereinandergeschaltete Begrenzerstufen LA1 bis LA7 auf. Alle Begrenzerstufen LA1 bis LA7 enthalten dabei, wie in den FIG 2, 3 und 4 gezeigt, jeweils einen npn-Transistor T1 und T2, deren gekoppelte Emitter unter Zwischenschalten einer Stromquelle an ein negatives Versorgungspotential GND und deren Kollektoren unter Zwischenschalten jeweils eines Widerstandes R1 bzw. R2 an ein positives Versorgungspotential VCC angeschlossen sind. Die Kollektoren der beiden Transistoren T1 und T2 bilden darüber hinaus die Signalausgänge AP und AN der jeweiligen Begrenzerstufe. An den gekoppelten Emittern der Transistoren T1 und T2 wird über einen Widerstand R3 jeweils ein Signalausgang AD angeschlossen. Gegenüber den restlichen Begrenzerstufen LA2 bis LA7 unterscheidet sich die Begrenzerstufe LA1, wie in FIG 2 gezeigt, zum einen durch eine von den übrigen Begrenzerstufen LA2 bis LA7 abweichende Ausbildung der Stromquelle und zum anderen durch eine abweichende Beschaltung des Eingangskreises. Die Stromquelle besteht hierbei aus drei Transistoren T25, T26, T27 deren Kollektoren miteinander und mit den gekoppelten Emittern der Transistoren T1 und T2 verbunden sind. Ebenso sind die Basen der drei Transistoren T25, T26, T27 miteinander und mit einem Referenzpotential VS gekoppelt. Der Emitter des Transistors T25 ist über einen Widerstand R4 und die gekoppelten Emitter der Transistoren T26 und T27 sind über einen Widerstand R5 mit dem negativen Versorgungspotential GND verbunden. Der von dieser Stromquelle gelieferte Strom ist in diesem Fall höher als der Strom der entsprechenden Stromquellen der restlichen Begrenzerstufen LA2 bis LA7. Weiterhin ist bei der Begrenzerstufe LA1 ein Widerstand R6 zwischen die als Signaleingänge EP und EN vorgesehenen Basen der beiden Transistoren T1 und T2 geschaltet. Zudem sind die Basen dieser beiden Transistoren T1 und T2 über jeweils einen Widerstand R7 bzw. R8 mit einem Referenzpotentialeingang VV verbunden.

Bei den übrigen Begrenzerstufen LA2 bis LA7 sind jeweils ein npn-Transistor T3 und T4 vorgesehen, deren Kollektoren mit dem positiven Versorgungspotential VCC verbunden sind und deren Basen Signaleingänge EP und EN dieser Begrenzerstufen LA2 bis LA7 bilden. Außerdem enthalten sie npn-Transistoren T5 und T6, deren Kollektoren jeweils mit den Emittern der Transistoren T3 und T4 und deren Emitter jeweils mit den Basen der Transistoren T1 und T2 direkt sowie über jeweils eine Stromquelle mit dem negativen Versorgungspotential GND verbunden sind. Die Stromquellen wiederum bestehen jeweils aus einem Transistor T28, T29, T30, deren Kollektoren mit den gekoppelten Emittern der Transistoren T1 und T2 bzw. dem Emitter des Transistors T5 bzw. dem Emitter des Transistors T6 verbunden sind und deren Basen miteinander sowie mit dem Referenzpotentialeingang VS dieser Begrenzerstufen LA2 bis LA7 gekoppelt sind. Die Emitter der Transistoren T28, T29, T30 sind über jeweils einen Widerstand R9, R10, R11 auf einen gemeinsamen Knotenpunkt geführt, der seinerseits über einen Widerstand R12 an das negative Versorgungspotential GND angeschlossen ist.

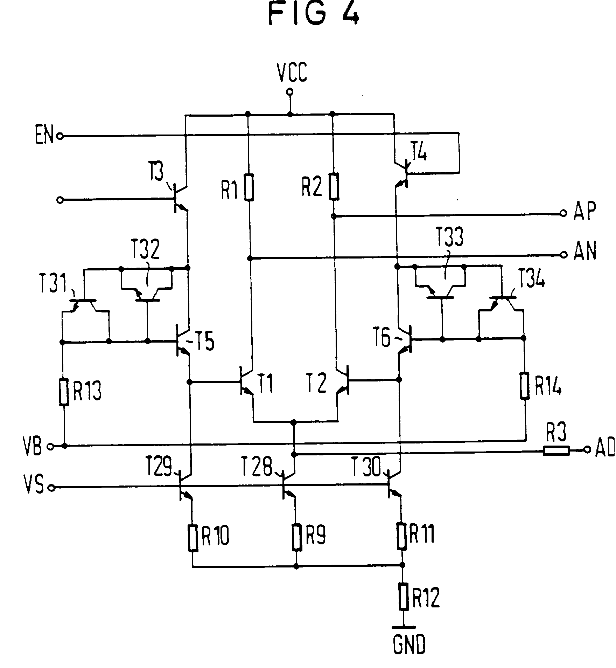

Die Begrenzerstufen LA2, LA4, LA6 unterscheiden sich von den Begrenzerstufen LA3, LA5, LA7 dadurch, daß bei den Transistoren T5 und T6 jeweils Basis und Kollektor miteinander verbunden sind. Dagegen ist bei den Begrenzerstufen LA3, LA5, LA7 zum einen zwischen die Kollektoren und die Basen der Transistoren T5 und T6 jeweils ein Kondensator geschaltet und zum anderen sind die Basen der Transistoren T5 und T6 über jeweils einen Widerstand R13 und R14 mit einem Referenzpotentialeingang VB gekoppelt. Die Kapazitäten werden dabei durch je zwei npn-Transistoren T31 und T32 bzw. T33 und T34 gebildet, wobei Kollektor und Emitter des Transistors T31 bzw. T33 mit der Basis des Transistors T32 bzw. T34 und umgekehrt verbunden sind. Durch unterschiedliche Ausbildung der Begrenzerstufen LA2, LA4, LA6 und der Begrenzerstufen LA3, LA5, LA7 erfolgt entweder eine Gleichstromkopplung oder eine Wechselstromkopplung mit der vorhergehenden Begrenzerstufe. Das bedeutet also, daß die Begrenzerstufen LA1 und LA2, LA3 und LA4, LA5 und LA6 gleichstromgekoppelt und die Begrenzerstufen LA2 und LA3, LA4 und LA5, LA6 und LA7 wechselstromgekoppelt sind. Die abweichende Ausbildung der Begrenzerstufe LA1 zielt auf größere Rauscharmut bei dieser mit Eingängen E+, E- verbundenen Begrenzerstufe LA1. Das hintereinanderschalten der einzelnen Stufen erfolgt nun jeweils durch Verbinden der Signalausgänge AP, AN mit den Signaleingängen EP, EN der nachfolgenden Stufe. Die Referenzpotentialeingänge VS aller Begrenzerstufen LA1 bis LA7 sind gemäß FIG 1 miteinander und mit einem Referenzpotentialeingang B1 verschaltet. Die Signalausgänge AP, AN der Begrenzerstufe LA7 sind mit Signalausgängen A+, A-gekoppelt. FIG 3 zeigt die Schaltung der Begrenzerstufen LA2, LA4, LA6 und FIG 4 die Schaltung der Begrenzerverstärker LA3, LA5, LA7.

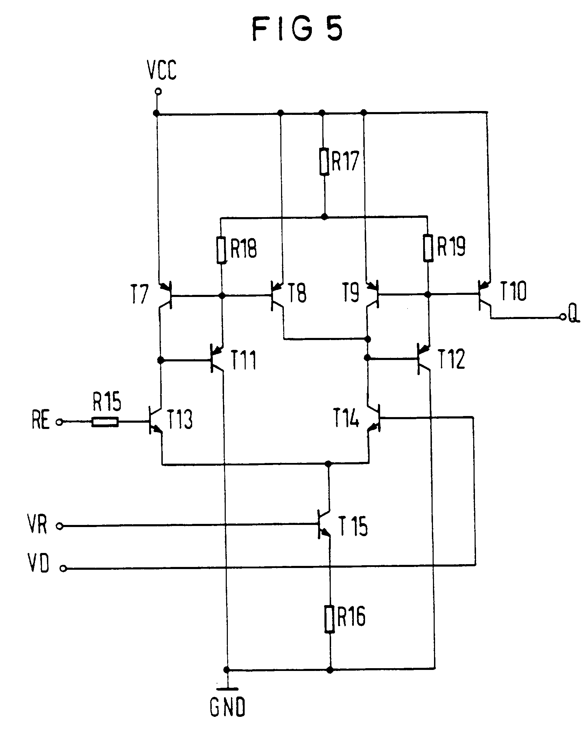

In FIG 5 der Zeichnung ist der Aufbau einer Detektorschaltung dargestellt. Diese besteht beispielsweise aus sieben identisch aufgebauten Detektorstufen DS1 bis DS7 mit jeweils vier pnp-Transistoren T7, T8, T9, T10, deren Basen paarweise miteinander gekoppelt sind und deren Emitter an das zweite Versorgungspotential angeschlossen sind. Außerdem sind zwei pnp-Transistoren T11 und T12 vorgesehen, deren Emitter jeweils mit den gekoppelten Basen der Transistoren T7 und T8 bzw. T9 und T10 und deren Kollektoren mit dem negativen Versorgungspotential GND verbunden sind. Ein npn-Transistor T13, dessen Kollektor mit dem Kollektor des Transistors T7 verbunden ist, und ein npn-Transistor T14, dessen Kollektor mit dem Kollektor des Transistor T9 verbunden ist, sind emitterseitig miteinander gekoppelt und über eine Stromquelle mit dem negativen Versorgungspotential GND verbunden. Die Basis des Transistors T13 ist über einen Widerstand R15 an einem Referenzpotentialeingang RE und die Basis des Transistors T14 ist an einem Signaleingang VD angeschlossen. Die Stromquelle besteht aus einem npn-Transistor T35, dessen Kollektor mit den gekoppelten Emittern der Transistoren T13 und T14 verschaltet ist, und aus einem Widerstand R16, der zwischen dem Emitter des Transistors T35 und das negative Versorgungspotential GND geschaltet ist. An der Basis des Transistors T35 ist ein Referenzpotentialeingang VR angeschlossen. Schließlich sind drei Widerstände R17, R18, R19 vorgesehen, die in Sternschaltung zwischen das positive Versorgungspotential VCC, die gekoppelten Basen der Transistoren T7 und T8 sowie die gekoppelten Basen der Transistoren T9 und T10 geschaltet sind. Gemäß FIG 1 sind die Signaleingänge VD der Detektorstufen DS1 bis DS7 mit den Signalausgängen AD der entsprechenden Begrenzerstufen LA1 bis LA7 verbunden. Sämtliche Referenzpotentialeingänge VR sind zusammengeführt und an einen Referenzpotentialeingang B2 angeschlossen. Ebenso sind die Signalausgänge Q aller Begrenzerstufen zusammengeführt und an einen Detektorausgang QT angeschlossen.

Wie in FIG 1 dargestellt ist der Referenzpotentialeingang VV der Begrenzerstufe LA1 mit einem Referenzpotentialausgang VV1 einer Referenzspannungsquelle REF1 verbunden. Die Referenzspannungsquelle REF1 weist darüber hinaus einen Referenzpotentialausgang RE1, der mit dem Referenzpotentialeingang RE der ersten Detektorstufe DS1 verbunden ist, und einen Referenzpotentialausgang RE2, der mit dem Referenzpotentialeingang RE der Detektorstufe DS2 verbunden ist, auf. Ein Referenzpotentialeingang VS1 ist an den Referenzpotentialeingang B1 angeschlossen. Zudem ist eine weitere Referenzspannungsquelle REF2 mit einem ebenfalls an dem Referenzpotentialeingang B1 angeschlossenen Referenzpotentialeingang VS2 und mit drei Referenzpotentialausgängen RE3, RE4 sowie VB1 vorgesehen. Der Referenzpotentialausgang VB1 ist dabei mit den Referenzpotentialeingängen VB der Begrenzerstufen LA3, LA5 und LA7 verschaltet. Der Referenzpotentialausgang RE3 ist mit den Referenzpotentialeingängen RE der Demodulatorstufen DS3, DS5 sowie DS7 und der Referenzpotentialausgang RE4 ist mit den Referenzpotentialeingängen RE der Detektorstufen DS4 und DS6 verbunden.

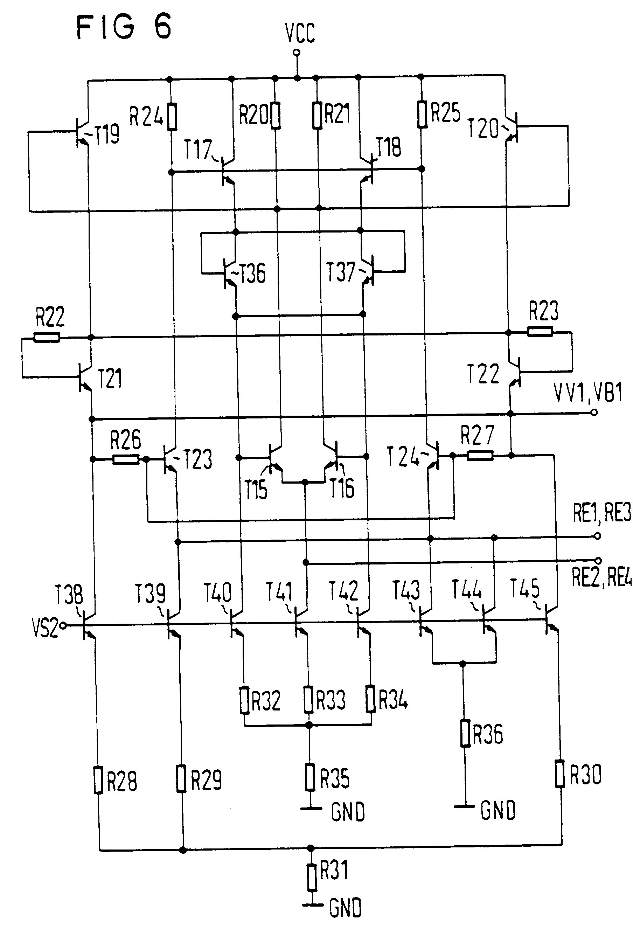

Der Aufbau der beiden Referenzspannungsquellen REF1 und REF2 ist in FIG 6 prinzipiell dargestellt. Dabei sind die gekoppelten Emitter zweier npn-Transistoren T15 und T16 unter Zwischenschalten einer Stromquelle an das negative Versorgungspotential GND angeschlossen. Deren Kollektoren wiederum sind unter Zwischenschalten jeweils eines Widerstandes R20 und R21 mit dem positiven Versorgungspotential VCC verbunden, während ihre Basen über jeweils eine Stromquelle mit dem negativen Versorgungspotential GND verschaltet sind. Zwei npn-Transistoren T17 und T18 sind kollektorseitig mit dem positiven Versorgungspotential VCC und emitterseitig über jeweils eine Diode in Durchlaßrichtung mit den Basen der Transistoren T15 und T16 gekoppelt. Die beiden Dioden werden durch zwei npn-Transistoren T36 und T37 gebildet, bei denen Basis und Kollektor jeweils miteinander verbunden sind. Außerdem sind zwei npn-Transistoren T19 und T20 vorgesehen, deren Kollektoren mit dem positiven Versorgungspotential VCC und deren Emitter unter Zwischenschalten jeweils der Kollektor-Emitter-Strecke eines Transistors T21 bzw. T22, bei dem Basis und Kollektor über einen Widerstand R22 bzw. R23 miteinander verbunden sind, an das negative Versorgungspotential GND angeschlossen. Die Kollektoren zweier npn-Transistoren T23 und T24 sind jeweils mit den Basen der Transistoren T17 und T18 direkt sowie über jeweils einen Widerstand R24 bzw. R25 mit dem positiven Versorgungspotential VCC gekoppelt. Ihre Basen sind jeweils über einen Widerstand R26 bzw. R27 an die Emitter der Transistoren T21 und T22 angeschlossen. Die Emitter der Transistoren T21 und T22 sind über jeweils eine Stromquelle mit dem negativen Versorgungspotential GND verbunden. Die einzelnen Stromquellen werden durch npn-Transistoren T38 bis T45 gebildet, deren Kollektor jeweils mit den Emittern der Transistoren T21, T23, T15 und T16, T24 und T22 verbunden sind. Die Emitter der Transistoren T38, T39 und T45 sind jeweils über Widerstände R28, R29 und R30 auf einen gemeinsamen Knotenpunkt geführt, der über einen Widerstand R31 an das negative Versorgungspotential GND angeschlossen ist. Die Emitter der Transistoren T40, T41 und T42 sind über Widerstände R32, R33 und R34 auf einen weiteren Knotenpunkt geführt, der über einen Widerstand R35 an dem negativen Versorgungspotential GND liegt. Schließlich sind die Emitter der Transistoren T43 und T44 miteinander gekoppelt und über einen Widerstand R36 auf das negative Versorgungspotential GND geführt. Die Basen der Transistoren T38 bis T45 sind miteinander und mit dem Referenzpotentialeingang VS2 gekoppelt. Die Referenzspannungsquellen REF1 und REF2 sind soweit im wesentlichen identisch zu den entsprechenden Begrenzerstufen und Detektorstufen ausgeführt. Sie unterscheiden sich nun darin, daß die Basen der Transistoren T19 und T20 sowie die Kollektoren der Transistoren T15 und T16 miteinander, die Basen und Emitter der Transistoren T17 und T18 jeweils miteinander, die Emitterund Kollektoren der Transistoren T21 und T22 miteinander und die Basen sowie Emitter der Transistoren T23 und T24 miteinander verschaltet sind. Die gekoppelten Emitter der Transistoren T21 und T22 sind dabei mit dem Referenzpotentialausgang VV1 bzw. dem Referenzpotentialausgang VB1 verbunden. Die Referenzpotentialausgänge RE1 bzw. RE3 sind an die gekoppelten Emitter der Transistoren T23 und T24 sowie die Referenzpotentialausgänge RE2 bzw. RE4 sind an die gekoppelten Emitter der Transistoren T15 und T16 angeschlossen. Die Referenzspannungsquellen REF1 und REF2 unterscheiden sich voneinander darin daß bei der Referenzspannungsquelle REF1 die Widerstände R22 und R23 und bei der Referenzspannungsquelle REF2 die Widerstände R26 und R27 möglichst geringe Werte annehmen bzw. durch einen Kurzschluß ersetzt werden.

## Patentansprüche

1. Schaltungsanordnung mit mindestens n=3 in Reihe geschalteten Begrenzerstufen (LA1 bis LA7) mit jeweils einem ersten und einem zweiten Transistor (T1, T2) des einen Leitungstyps, deren gekoppelte Emitter unter Zwischenschalten einer Stromquelle (T25, T26, T27, R4, R5; T28, R9) an ein erstes Versorgungspotential (GND) und deren Signalausgänge (AP, AN) bildende Kollektoren unter Zwischenschalten jeweils eines Widerstandes (R1, R2) an ein zweites Versorgungspotential (VCC) angeschlossen sind, und mit n jeweils den Begrenzerstufen (LA1 bis LA7) zugeordneten Feldstärkedetektorstufen (DS1 bis DS7), deren Eingänge (VD) jeweils mit den gekoppelten Emittern der zugehörigen Begrenzerstufe (LA1 bis LA7) verbunden sind und deren Ausgänge (Q) miteinander gekoppelt sind, **gekennzeichnet durch** mindestens eine der Begrenzerstufe (LA2 bis LA7) mit einem dritten und vierten Transistor (T3, T4) des einen Leitungstyps, deren Kollektoren mit dem zweiten Versorgungspotential (VCC) verbunden sind und deren Basen als Signaleingänge (EP, EN) dieser Begrenzerstufen vorgesehen sind, und mit einem zwischen Basis und Kollektor rückgekoppelten fünften und sechsten Transistor (T5, T6) des einen Leitungstyps, deren Kollektoren jeweils mit den Emittern von drittem und viertem Transistor (T3, T4) und deren Emitter jeweils mit den Basen von erstem und zweitem Transistor (T1, T2) direkt sowie über jeweils eine Stromquelle (T29, R10; T30; R11) mit dem ersten Versorgungspotential (GND) verbunden sind und durch eine der Reihe nach abwechselnde Gleichstrom- oder Wechselstromkopplung der in Reihe geschalteten Begrenzerstufen (LA1 bis LA7) untereinander.

2. Schaltungsanordnung nach Anspruch 1,
**gekennzeichnet durch** Begrenzerstufen (LA2, LA4, LA6), bei denen zur Gleichstromankopplung an die vorhergehende Begrenzerstufe (LA1, LA3, LA5) Kollektor und Basis von fünftem bzw. sechstem Transistor (T5, T6) jeweils direkt miteinander verbunden sind.

3. Schaltungsanordnung nach Anspruch 1,
**gekennzeichnet durch** Begrenzerstufen (LA3, LA5, LA7), bei denen zur Wechselstromankopplung an die vorhergehende Begrenzerstufe (LA2, LA4, LA6) zwischen Kollektor und Basis von fünftem und sechstem Transistor (T5, T6) jeweils eine Kapazität geschaltet ist.

4. Schaltungsanordnung nach Anspruch 3,
**dadurch gekennzeichnet,** daß die Kapazitäten jeweils durch zwei Transistoren (T31, T32; T33, T34) des gleichen Leitungstyps gebildet werden, wobei jeweils Kollektor und Emitter eines Transistors mit den Basen des jeweils anderen Transistors und umgekehrt verbunden sind.

5. Schaltungsanordnung nach Anspruch 3 oder 4,
**dadurch gekennzeichnet,** daß an die Basis von fünftem und sechstem Transistor (T5, T6) ein Referenzpotential (VB) angelegt ist.

6. Schaltungsanordnung nach einem der Ansprüche 1 bis 5,
**gekennzeichnet durch** Detektorstufen (DS1 bis DS7) mit einem siebten und achten sowie mit einem neunten und zehnten Transistor (T7 bis T10) des anderen Leitungstyps, deren Basen paarweise miteinander gekoppelt sind und deren Emitter an das zweite Versorgungspotential (VCC) angeschlossen sind, mit einem elften und zwölften Transistor (T11, T12) des anderen Leitungstyps, deren Emitter jeweils mit den gekoppelten Basen von siebtem und achtem bzw. neuntem und zehntem Transistor (T7 bis T10) und deren Kollektoren mit dem ersten Versorgungspotential (GND) verbunden sind, mit einem dreizehnten Transistor (T13) des einen Leitungstyps, dessen Kollektor mit der Basis des elften Transistors (T11) und dem Kollektor des siebten Transistors (T7) verbunden ist und dessen Basis an mindestens eine Referenzspannungsquelle angeschlossen ist, mit einem vierzehnten Transistor (T14) des einen Leitungstyps, dessen Kollektor mit der Basis des zwölften Transistors (T12) sowie mit dem Kollektor von achtem und neuntem Transistor (T8, T9) verbunden ist und dessen Basis als Eingang (VD) der jeweiligen Detektorstufe vorgesehen ist, mit einer Stromquelle (T35, R16), die zwischen die miteinander gekoppelten Emitter von dreizehntem und vierzehntem Transistor (T13, T14) und das erste Versorgungspotential (GND) geschaltet ist, und mit drei Widerständen (R17, R18, R19), die in Sternschaltung zwischen das zweite Versorgungspotential (VCC), die gekoppelten Basen von siebtem und achtem Transistor (T7, T8) und die gekoppelten von neuntem und zehntem Transistor (T9, T10) geschaltet sind.

7. Schaltungsanordnung nach Anspruch 6,
**gekennzeichnet durch** Referenzspannungsquelle mit einem fünfzehnten und sechszehnten Transistor (T15, T16) des einen Leitungstyps, deren gekoppelte Emitter unter Zwischenschalten einer Stromquelle (T41, R33) an das erste Versorgungspotential (GND) und deren Kollektoren unter Zwischenschalten jeweils eines Widerstandes (R20, R21) an das zweite Versorgungspotential (VCC) angeschlossen sind, sowie deren Basen über jeweils eine Stromquelle (T40, R32; T42, R34) mit dem ersten Versorgungspotential (GND) verbunden sind, mit einem siebzehnten und achtzehnten Transistor (T17, T18) des einen Leitungstyps, deren Kollektoren mit dem zweiten Versorgungspotential (VCC) und deren Emitter jeweils über eine Diode (T36, T37) in Durchlaßrichtung mit den Basen von fünfzehntem und sechzehntem Transistor (T15, T16) verbunden sind, mit einem neunzehnten und zwanzigsten Transistor (T19, T20) des einen Leitungstyps, deren Kollektoren mit dem zweiten Versorgungspotential (VCC) und deren Emitter unter Zwischenschalten jeweils der Kollektor-Emitter-Strecke eines einundzwanzigsten bzw. zweiundzwanzigsten Transistors (T21, T22) des einen Leitungstyps, bei dem Basis und Emitter über einen Widerstand (R22, R23) miteinander verschaltet sind, und jeweils einer Stromquelle (T38, R28; T45, T30) mit dem ersten Versorgungspotential (GND) verbunden sind und mit einem dreiundzwanzigsten und vierundzwanzigsten Transistor (T23, T24) deren Kollektoren jeweils mit den Basen von siebzehntem und achtzehntem Transistor (T17, T18) sowie jeweils über einen Widerstand (R24, R25) mit dem zweiten Versorgungspotential (VCC) verbunden sind, deren Basen über jeweils einen Widerstand (R26, R27) an die Emitter von einundzwanzigstem und zweiundzwanzigstem Transistor (T21, T22) angeschlossen sind und deren Emitter über jeweils eine Stromquelle (T39, R29; T43, T44, R36) mit dem ersten Versorgungspotential (GND) verbunden sind, wobei die Basen von neunzehntem und zwanzigstem Transistor (T19, T20) und die Kollektoren von fünfzehntem und sechzehntem Transistor (T15, T16) miteinander, die Basen udn Emitter von siebzehntem und achtzehntem Transistor (T17, T18) jeweils miteinander, die Basen von fünfzehntem und sechzehntem Transistor (T15, T16) miteinander, die Emitter und Kollektoren von einundzwanzigstem und zweiundzwanzigstem Transistor (T21, T22) miteinander und die Basen und Emitter von dreiundzwanzigstem und vierundzwanzigstem Transistor (T23, T24) miteinander verbunden sind und wobei jeweils die gekoppelten Emitter von fünfzehntem und sechzehntem Transistor (T15, T16) sowie von dreiundzwanzigstem udn vierundzwanzigstem Transistor (T23, T24) als Referenzpotentiale führende Ausgänge (RE1 bis RE4) der Referenzspannungsquelle vorgesehen sind.

8. Schaltungsanordnung nach Anspruch 7,
**dadurch gekennzeichnet,** daß die Emitter von einundzwanzigstem und zweiundzwanzigstem Transistor (T21, T22) als weitere Referenzpotentiale (VV, VB) führende weitere Ausgänge (VV1, VB1) vorgesehen sind.

## Claims

1. Circuit arrangement having at least n=3 series-connected limiter stages (LA1 to LA7) each having a first and a second transistor (T1, T2) of the one conduction type, the coupled emitters of which transistors (T1, T2) are connected, with the interposition of a current source (T25, T26, T27, R4, R5; T28, R9), to a first supply potential (GND) and the collectors of which transistors (T1, T2), which collectors form signal outputs (AP, AN), are connected, with the interposition of a respective resistor (R1, R2), to a second supply potential (VCC), and having n field strength detector stages (DS1 to DS7) which are respectively assigned to the limiter stages (LA1 to LA7), the inputs (VD) of which field strength detector stages (DS1 to DS7) are respectively connected to the coupled emitters of the associated limiter stage (LA1 to LA7) and the outputs (Q) of which field strength detector stages (DS1 to DS7) are coupled to one another, characterized by at least one of the limiter stages (LA2 to LA7) having a third and a fourth transistor (T3, T4) of the one conduction type, the collectors of which transistors (T3, T4) are connected to the second supply potential (VCC) and the bases of which transistors (T3, T4) are provided as signal inputs (EP, EN) of these limiter stages, and having a fifth and a sixth transistor (T5, T6) of the one conduction type, which transistors (T5, T6) have feedback between the base and the collector, the collectors of which transistors (T5, T6) are respectively connected to the emitters of the third and fourth transistors (T3, T4) and the emitters of which transistors (T5, T6) are respectively connected directly to the bases of the first and second transistors (T1, T2) and are also connected to the first supply potential (GND) via a respective current source (T29, R10; T30; R11), and characterized by the series-connected limiter stages (LA1 to LA7) being alternately DC- or AC-coupled together in order.

2. Circuit arrangement according to Claim 1, characterized by limiter stages (LA2, LA4, LA6) in which the collector and base of the fifth and sixth transistors (T5, T6) are in each case connected directly to one another for the purpose of DC coupling to the preceding limiter stage (LA1, LA3, LA5).

3. Circuit arrangement according to Claim 1, characterized by limiter stages (LA3, LAS, LA7) in which a capacitance is connected in each case between the collector and base of the fifth and sixth transistors (T5, T6) for the purpose of AC coupling to the preceding limiter stage (LA2, LA4, LA6).

4. Circuit arrangement according to Claim 3, characterized in that the capacitances are in each case formed by two transistors (T31, T32; T33, T34) of the same conduction type, the collector and emitter of one transistor in each case being connected to the base of the respective other transistor, and vice versa.

5. Circuit arrangement according to Claim 3 or 4, characterized in that a reference potential (VB) is applied to the base of the fifth and of the sixth transistor (T5, T6).

6. Circuit arrangement according to one of Claims 1 to 5, characterized by detector stages (DS1 to DS7) having a seventh and eighth as well as a ninth and tenth transistor (T7 to T10) of the other conduction type, the bases of which transistors (T7 to T10) are coupled to one another in pairs and the emitters of which transistors (T7 to T10) are connected to the second supply potential (VCC), having an eleventh and a twelfth transistor (T11, T12) of the other conduction type, the emitters of which transistors (T11, T12) are respectively connected to the coupled bases of the seventh and eighth and, respectively, of the ninth and tenth transistors (T7 to T10) and the collectors of which transistors (T11, T12) are connected to the first supply potential (CND), having a thirteenth transistor (T13) of the one conduction type, the collector of which transistor (T13) is connected to the base of the eleventh transistor (T11) and to the collector of the seventh transistor (T7) and the base of which transistor (T13) is connected to at least one reference voltage source, having a fourteenth transistor (T14) of the one conduction type, the collector of which transistor (T14) is connected to the base of the twelfth transistor (T12) and also to the collector of the eighth and of the ninth transistor (T8, T9) and the base of which transistor (T14) is provided as the input (VD) of the respective detector stage, having a current source (T15, R16) which is connected between the emitters, which are coupled to one another, of the thirteenth and fourteenth transistors (T13, T14) and the first supply potential (CND), and having three resistors (R17, R18, R19) which are connected in star connection between the second supply potential (VCC), the coupled bases of the seventh and eighth transistors (T7, T8) and the coupled bases of the ninth and tenth transistors (T9, T10).

7. Circuit arrangement according to Claim 6, characterized by a reference voltage source having a fifteenth and a sixteenth transistor (T15, T16) of the one conduction type, the coupled emitters of which transistors (T15, T16) are connected, with the interposition of a current source (T41, R33), to the first supply potential (CND) and the collectors of which transistors (T15, T16) are connected, with the interposition of a respective resistor (R20, R21), to the second supply potential (VCC), and the bases of which transistors (T15, T16) are connected to the first supply potential (CND) via a respective current source (T40, R32; T42, R34), having a seventeenth and an eighteenth transistor (T17, T18) of the one conduction type, the collectors of which transistors (T17, T18) are connected to the second supply potential (VCC) and the emitters of which transistors (T17, T18) are respectively connected to the bases of the fifteenth and sixteenth transistors (T15, T16) via a diode (T36, T37) in the forward direction, having a nineteenth and a twentieth transistor (T19, T20) of the one conduction type, the collectors of which transistors (T19, T20) are connected to the second supply potential (VCC) and the emitters of which transistors (T19, T20) are connected, with the interposition of the respective collector-emitter path of a twenty-first and a twenty-second transistor (T21, T22) of the one conduction type, in which the base and emitter are interconnected via a resistor (R22, R23), and of a respective current source (T38, R28; T45, R30), to the first supply potential (CND), and having a twenty-third and a twenty-fourth transistor (T23, T24), the collectors of which transistors (T23, T24) are respectively connected to the bases of the seventeenth and eighteenth transistors (T17, T18) and also, via a respective resistor (R24, R25), to the second supply potential (VCC), the bases of which transistors (T23, T24) are connected via a respective resistor (R26, R27) to the emitters of the twenty-first and twenty-second transistors (T21, T22) and the emitters of which transistors (T23, T24) are connected via a respective current source (T39, R29; T43, T44, R36) to the first supply potential (CND), the bases of the nineteenth and twentieth transistors (T19, T20) and the collectors of the fifteenth and sixteenth transistors (T15, T16) being connected to one another, the bases and emitters of the seventeenth and eighteenth transistors (T17, T18) being in each case connected to one another, the bases of the fifteenth and sixteenth transistors (T15, T16) being connected to one another, the emitters and collectors of the twenty-first and twenty-second transistors (T21, T22) being connected to one another and the bases and emitters of the twenty-third and twenty-fourth transistors (T23, T24) being connected to one another, and the coupled emitters of the fifteenth and sixteenth transistors (T15, T16) and of the twenty-third and twenty-fourth transistors (T23, T24) in each case being provided as outputs (RE1 to RE4), of the reference voltage source, which carry reference potentials.

8. Circuit arrangement according to Claim 7, characterized in that the emitters of the twenty-first and twenty-second transistors (T21, T22) are provided as further outputs (VV1, VB1) carrying further reference potentials (VV, VB).

## Revendications

1. Montage comportant au moins un n=3 étages (LA1 à LA7) limiteurs branchés en série et comportant chacun des premier et second transistors (T1,T2) d'un premier type de conductivité, dont les émetteurs couplés sont connectés à un premier potentiel (GND) d'alimentation par l'intermédiaire d'une source (T25,T26,T27,R4,R5; T28,R9) de courant et dont les collecteurs formant des sorties (AP,AN) de signaux sont connectés à un second potentiel (VCC) d'alimentation par l'intermédiaire d'une résistance (R1,R2), le montage comportant n étages (DS1 à DS7) détecteurs d'intensité de champ, qui sont associés respectivement aux étages limiteurs (LA1 à LA7), dont les entrées (VD) sont reliées aux émetteurs couplés de l'étage limiteur associé (LA1 à LA7) et dont les sorties (Q) sont couplées l'une à l'autre,
caractérisé par le fait qu'au moins l'un des étages limiteurs (LA2 à LA7) comporte des troisième et quatrième transistors (T3,T4) du premier type de conductivité, dont les collecteurs sont reliés au second potentiel (VCC) d'alimentation et dont les bases sont prévues comme entrées (EP, EN) de signaux de ces étages limiteurs, et des cinquième et sixième transistors (T5,T6) du premier type de conductivité, dont les bases et les collecteurs sont interconnectés, dont les collecteurs sont reliés respectivement aux émetteurs des troisième et quatrième transistors (T3,T4) et dont les émetteurs sont reliés respectivement aux bases des premier et deuxième transistors (T1,T2) directement ainsi qu'au premier potentiel (GND) d'alimentation par l'intermédiaire d'une source de courant (T29,R10;T30;R11) et les étages limiteurs (LA1 à LA7) branchés en série sont couplés les uns aux autres en alternance en courant continu et en courant alternatif dans l'ordre.

2. Montage suivant la revendication 1,
caractérisé par des étages limiteurs (LA2,LA4,LA6), dans lesquels le collecteur et la base des cinquième ou sixième transistors (T5, T6) sont reliés l'un à l'autre directement pour le couplage en courant continu à l'étage limiteur précédent (LA1,LA3,LA5).

3. Montage suivant la revendication 1,
caractérisé par les étages limiteurs (LA3,LA5,LA7), dans lesquels une capacité est branchée entre le collecteur et la base des cinquième et sixième transistors (T5,T6) pour le couplage en courant alternatif à l'étage limiteur précédent (LA2,LA4,LA6).

4. Montage suivant la revendication 3,
caractérisé en ce que les capacités sont formées chacune de deux transistors (T31, T32; T33, T34) du même type de conductivité, les collecteurs et l'émetteur de chacun des transistors étant reliés à la base de l'autre transistor et inversement.

5. Montage suivant la revendication 3 ou 4,
caractérisé en ce qu'un potentiel (GB) de référence est appliqué à la base des cinquième et sixième transistors (T5, T6).

6. Montage suivant l'une des revendications 1 à 5,
caractérisé par des étages détecteurs (DS1 à DS7) comportant des septième et huitième ainsi que des neuvième et dixième transistors (T7 à T10) de l'autre type de conductivité, dont les bases sont couplées l'une à l'autre par paires et dont les émetteurs sont reliés au second potentiel (VCC) d'alimentation, des onzième et douzième transistors (T11,T12) de l'autre type de conductivité, dont les émetteurs sont reliés respectivement aux bases couplées des septième et huitième ou neuvième et dixième transistors (T7 à T10) et dont les collecteurs sont reliés au premier potentiel d'alimentation (GND), un treizième transistor (T13) du premier type de conductivité, dont le collecteur est relié à la base du onzième transistor (T11) et au collecteur du septième transistor (T7) et dont la base est connectée à au moins une source de tension de référence, un quatorzième transistor (T14) du premier type de conductivité, dont le collecteur est relié à la base du douzième transistor (T12) ainsi qu'au collecteur des huitième et neuvième transistors (T8,T9) et dont la base est prévue comme entrée (VD) de l'étage détecteur, une source (T35, R16) de courant, qui est branchée entre les émetteurs couplés l'un à l'autre des treizième et quatorzième transistors (T13,T14) et le potentiel (GND) d'alimentation, et trois résistances (R17,R18,R19), qui sont branchées en étoile entre le second potentiel (VCC) d'alimentation, les bases couplées des septième et huitième transistors (T7,T8) et les bases couplées des neuvième et dixième transistors (T9,T10).

7. Montage suivant la revendication 6,
caractérisé par une source de tension de référence comportant des quinzième et seizième transistors (T15,T16) du premier type de conductivité, dont les émetteurs couplés sont connectés au premier potentiel (GND) d'alimentation par l'intermédiaire d'une source (T41,R33) de courant, dont les collecteurs sont connectés au second potentiel (VCC) d'alimentation par l'intermédiaire d'une résistance (R20,R21) pour chacun et dont les bases sont reliées par l'intermédiaire d'une source (T40,R32;T42;R34) de courant au premier potentiel (GND) d'alimentation, des dix-septième et dix-huitième transistors (T17,T18) du premier type de conductivité, dont les collecteurs sont reliés au second potentiel (VCC) d'alimentation et dont les émetteurs sont reliés chacun par l'intermédiaire d'une diode (T36,T37) dans le sens passant aux bases des quinzième et seizième transistors (T15,T16), des dix-neuvième et vingtième transistors (T19,T20) du premier type de conductivité, dont les collecteurs sont reliés au second potentiel (VCC) d'alimentation et dont les émetteurs sont reliés au premier potentiel (GND) d'alimentation par l'intermédiaire de la voie collecteur-émetteur de vingt-unième et vingt-deuxième transistors (T21,T22) du premier type de conductivité dont les bases et les émetteurs sont reliés par l'intermédiaire d'une résistance (R22,R23) l'un à l'autre, et par l'intermédiaire d'une source de courant (T38;R28;T45,T30), et des vingt-troisième et vingt-quatrième transistors (T23,T24), dont les collecteurs sont reliés chacun aux bases des dix-septième et dix-huitième transistors (T17,T18) ainsi que chacun par l'intermédiaire d'une résistance (R24,R25) au second potentiel (VCC) d'alimentation, dont les bases sont connectées chacune par l'intermédiaire d'une résistance (R26, R27) aux émetteurs des vingt-et-unième et vingt-deuxième transistors (T21,T22) et dont les émetteurs sont reliés chacun par l'intermédiaire d'une source (T39,R29;T43,T44,R36) de courant au premier potentiel (GND) d'alimentation, les bases des dix-neuvième et vingtième transistors (T19,T20) étant reliées les unes aux autres et les collecteurs des quinzième et seizième transistors (T15, T16) étant reliés les uns aux autres, les bases des dix-septième et dix-huitième transistors (T17,T18) étant reliées les unes aux autres et leurs émetteurs l'étant aussi, les bases des quinzième et seizième transistors (T15,T16) étant reliées l'une à l'autre, les émetteurs des vingt-et-unième et vingt-deuxième transistors (T21,T22) étant reliés les uns aux autres et leurs collecteurs l'étant aussi, les bases des vingt-troisième et vingt-quatrième transistors (T23,T24) étant reliées les unes aux autres et leurs émetteurs l'étant aussi, les émetteurs couplés des quinzième et seizième transistors (T15,T16) ainsi que des vingt-troisième et vingt-quatrième transistors (T23,T24) étant prévus comme sorties (RE1 à RE4), conduisant des potentiels de référence, de la source de tension de référence.

8. Montage suivant la revendication 7,
caractérisé en ce que les émetteurs des vingt-et-unième et vingt-deuxième transistors (T21,T22) sont prévus comme autres sorties (VV1,VB1) conduisant d'autres potentiels (VV,VB) de référence.
